# FASCICULE DE BREVET EUROPEEN

(11) **EP 3 756 852 B1**
(45) Date de publication et mention de la délivrance du brevet: **07.09.2022**
(21) Numéro de dépôt: 20181573.5
(22) Date de dépôt: 23.06.2020
(51) Int. Cl.: B29C 45/14, B29C 45/00, B60R 16/02, H01L 33/00, H01L 33/08, H01L 33/20, H01L 25/075, H01L 27/15, H01L 33/18, H01L 33/30, H01L 33/32

(54) **PROCÉDÉ DE FABRICATION D'UNE PIÈCE DE CARROSSERIE COMPRENANT UN DISPOSITIF ÉLECTRIQUE**
VERFAHREN ZUR HERSTELLUNG EINES KAROSSERIETEILS, DAS EINE ELEKTRISCHE VORRICHTUNG UMFASST
METHOD FOR MANUFACTURING A BODYWORK PART COMPRISING AN ELECTRICAL DEVICE

(30) Priorité: 25.06.2019 FR 1906896
(43) Date de publication de la demande: 30.12.2020
(73) Titulaire: Compagnie Plastic Omnium, 69007 Lyon (FR)
(72) Inventeur: TRESSE, M. David, 01150 Sainte-Julie (FR); BOISSON, Damien, 01150 Sainte-Julie (FR); JACQUEMET, Thierry, 01150 Sainte-Julie (FR)
(74) Mandataire: LLR

(56) Documents cités:
- WO-A1-2018/109340
- WO-A1-2019/043202
- WO-A1-2019/202154
- DATABASE WPI Week 201768 Thomson Scientific, London, GB; AN 2017-62208N XP002798257, -& CN 107 117 318 A (WUHAN AVIATION INSTR CO LTD) 1 septembre 2017 (2017-09-01)

## Description

L'invention concerne les pièces de carrosserie de véhicule automobile comprenant au moins un dispositif électrique et plus particulièrement les procédés de fabrication de telles pièces.

Les pièces de carrosserie embarquent de plus en plus de dispositifs électriques assurant des fonctions différentes. Il peut par exemple s'agir de capteurs de distance montés au niveau de la face interne de la pièce de carrosserie, c'est-à-dire celle n'étant pas visible lorsque la pièce de carrosserie est montée sur un véhicule automobile. Dans ce cas, et pour assurer un fonctionnement optimal de tels capteurs de distance qui pourrait être gêné par la présence de givre sur la pièce de carrosserie, un système de dégivrage (par exemple un réseau de fils de cuivre) peut être surmoulé dans la pièce de carrosserie pour dégivrer cette dernière si besoin. Il peut également être possible de surmouler dans une pièce de carrosserie un dispositif d'éclairage afin de réaliser une signature lumineuse au niveau de cette dernière. Une pièce de carrosserie peut également comprendre plusieurs dispositifs électriques assurant les mêmes fonctions et/ou des fonctions différentes.

Les différents dispositifs électriques surmoulés dans une pièce de carrosserie ont besoin d'un apport en énergie pour pouvoir fonctionner. Afin de permettre leur raccordement à une source d'énergie, un élément de connexion est présent sur le dispositif électrique. Cet élément est placé à l'intérieur d'un moule avec le dispositif électrique. Le moule est ménagé de manière à isoler l'élément de connexion afin que ce dernier ne soit pas recouvert de matière plastique. Le dispositif électrique peut ensuite être connecté à une source d'énergie par l'intermédiaire de l'élément de connexion.

Un tel procédé présente néanmoins plusieurs inconvénients.

Tout d'abord, il est nécessaire d'avoir un moule adapté, c'est-à-dire comprenant au moins une cavité pour pouvoir protéger le ou les éléments de connexion lors du moulage de la pièce de carrosserie. Cela implique d'avoir un moule ayant une configuration spéciale pour chaque configuration de pièces (comprenant un nombre variable de dispositifs électriques positionnés à des endroits pouvant variés d'une pièce de carrosserie à une autre). Cela complexifie le procédé de moulage des pièces de carrosserie et a également un impact sur les coûts de fabrication de ces dernières.

De plus, l'aménagement de la ou des cavités peut conduire à l'apparition de défauts d'aspect au niveau de la pièce moulée, comme par exemple des retassures.

Enfin, et pour éviter d'avoir à ménager trop de cavités à l'intérieur du moule, un seul élément de connexion peut être prévu par dispositif électrique. Dans le cas d'un réseau de fils de cuivre, cela implique de devoir rallonger la longueur totale de fils pour avoir un point d'entrée et de sortie situés au même endroit. Cela peut conduire à une perte de puissance au niveau du dispositif de dégivrage, et donc à un dégivrage hétérogène ou insuffisant.

Le document WO 2019/043202 A1 décrit un procédé de fabrication d'une pièce de carrosserie selon le préambule de la revendication 1. Le document WO 2018/109340 A1 décrit un procédé de fabrication de pièces de carrosserie.

L'invention a notamment pour but de fournir un procédé de fabrication de pièces de carrosserie comprenant au moins un dispositif électrique moins complexe que selon l'art antérieur compte tenu de la nécessité de connexion des dispositifs électriques surmoulés.

A cet effet l'invention a pour objet un procédé de fabrication d'une pièce de carrosserie de véhicule automobile comprenant au moins un dispositif électrique, le procédé comprenant les étapes suivantes :
- on surmoule un corps principal de la pièce de carrosserie sur le dispositif électrique,
- on retire au moins une partie du corps principal recouvrant au moins un élément de contact électrique du dispositif électrique, et
- on connecte l'élément de contact électrique à un élément de connexion du dispositif électrique à une source d'énergie.

Ainsi, on obtient un procédé dans lequel il n'est pas nécessaire de prévoir une ou plusieurs zones isolant un ou des éléments de connexion lors du moulage. En effet, l'élément de contact électrique est dans un premier temps recouvert par la matière plastique du corps principal puis est mis à nu par la suite afin de pouvoir le connecter à un élément de connexion du dispositif électrique à une source d'énergie. Il est donc possible de standardiser les moules de fabrication ainsi que le procédé de fabrication et ce que la pièce de carrosserie comprenne ou non un ou plusieurs dispositifs électriques puis d'ajouter une étape de reprise de la pièce de carrosserie si cette dernière comprend au moins un dispositif électrique surmoulé.

De plus, l'absence de dispositifs de connexion protégés lors du moulage évite l'apparition des défauts d'aspects mentionnés ci-dessus avec un surmoulage sans les obstacles constitués par ces zones.

Enfin, un tel procédé confère plus de liberté dans le placement du ou des dispositifs électriques ainsi qu'au niveau des zones de connexion de ces derniers à une source d'énergie. En effet, il est possible de placer un ou des éléments de contact électriques à différents endroits puis de les mettre à nu par la suite. Dans le cas d'un réseau de fils de cuivre en tant que dispositif de dégivrage, il est par exemple possible de prévoir deux éléments de contact électrique dans deux zones différentes de la pièce de carrosserie.

Cela permet de réduire la longueur de fils et donc d'éviter une perte de puissance telle que celle mentionnée ci-dessus.

Le procédé selon l'invention peut en outre comprendre au moins une des caractéristiques suivantes :
- le dispositif électrique est un système de dégivrage d'une pièce de carrosserie,
- l'élément de contact électrique est un plot en étain. Il s'agit d'un élément simple et pour lequel la réalisation d'une reprise de contact est aisée,
- le dispositif électrique est surmoulé sur une face externe du corps principal visible depuis l'extérieur d'un véhicule automobile sur lequel la pièce de carrosserie est montée. On obtient dès lors un dégivrage optimal si le dispositif électrique est un système de dégivrage et ce sans avoir à utiliser une quantité trop importante d'énergie,
- le dispositif électrique est disposé sur un film, le corps principal étant surmoulé sur le film. Le dispositif électrique est dès lors plus facile à manipuler, notamment pour sa mise en place dans le moule, mais également moins sujet à une dérive lors du moulage,
- on retire la partie du corps principal recouvrant l'élément de contact électrique par fraisage,
- la partie du corps principal recouvrant l'élément de contact électrique est retirée par cassure d'une zone de résistance mécanique inférieure au reste du corps principal ménagée autour de la partie du corps principal recouvrant l'élément de contact électrique. Le retrait de la partie du corps principal recouvrant l'élément de contact électrique est donc aisé,
- la taille de l'élément de contact électrique est supérieure à la taille de la partie du corps principal le recouvrant étant retirée. Ainsi, on minimise les risques de retirer une partie du corps principal derrière laquelle l'élément de contact électrique serait absent afin de s'assurer que ce dernier soit mis à nu,
- l'élément de connexion du dispositif électrique à une source d'énergie comprend un fil conducteur, connecté par soudage à l'élément de contact électrique, et
- l'élément de connexion du dispositif électrique à une source d'énergie comprend un contacteur à ressort, l'élément de contact électrique et l'élément de connexion du dispositif électrique à une source d'énergie étant connectés en montant le contacteur à ressort dans une cavité ménagée par le retrait de la partie du corps principal recouvrant l'élément de contact électrique. Ainsi, la reprise de contact électrique est obtenue de manière très simple.

L'invention a également pour objet une pièce de carrosserie obtenue par le procédé selon l'invention.

### Brève description des figures

L'invention sera mieux comprise à la lecture de la description qui va suivre donnée uniquement à titre d'exemple et faite en se référant aux dessins annexés dans lesquels :
[fig.1] la figure 1 est une vue en coupe d'un film comprenant un dispositif électrique selon l'invention,
[fig.2] la figure 2 est une vue en coupe d'une première pièce intermédiaire après l'étape de surmoulage du procédé selon l'invention ;
[fig.3] la figure 3 est une vue en coupe d'une pièce de carrosserie lors de l'étape de retrait d'une partie du corps principal du procédé selon l'invention ;
[fig.4] la figure 4 est une vue en coupe d'une seconde pièce intermédiaire après l'étape de retrait d'une partie du corps principal du procédé selon l'invention ; et

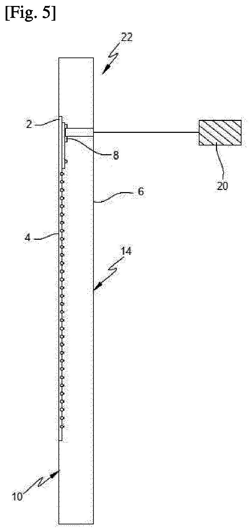

[fig.5] la figure 5 est une vue en coupe d'une pièce de carrosserie après l'étape de connexion du procédé selon l'invention.

### Description détaillée

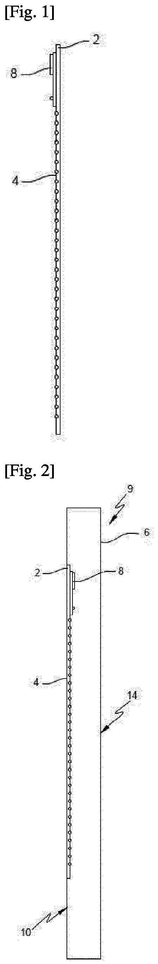

On se réfère désormais à la figure 1 représentant un film 2 comprenant un dispositif électrique 4. Le dispositif électrique 4 peut par exemple être collé sur le film 2, ou le film 2 peut être surmoulé sur le dispositif électrique 4. Le dispositif électrique 4 est en l'occurrence un dispositif dégivrant. Comme expliqué plus haut, il peut également s'agir d'un dispositif lumineux (par exemple un film de LEDs) ou de tout autre dispositif électrique pouvant être surmoulé dans une pièce de carrosserie. Aussi, le nombre de dispositifs électriques 4 présents sur un film 2 peut être supérieur à un, que ces derniers aient la même fonction ou des fonctions différentes. Il peut par exemple y avoir autant de dispositifs dégivrants qu'il y a de capteurs de distance montés au niveau d'une pièce de carrosserie. Il est également possible de monter plusieurs dispositifs dégivrants en parallèles afin d'obtenir un dégivrage homogène et un système de dégivrage opérationnel et ce même si l'un des dispositifs dégivrants est défaillant (par exemple par rupture d'un fil de cuivre). La présence du film 2 permet de faciliter la manipulation du ou des dispositifs électriques 4.

Nous décrirons par la suite le cas d'un dispositif dégivrant, bien que le dispositif électrique puisse être différent. Ce dernier peut être constitué de fils de cuivre, ces fils étant arrangés de manière à être transparents aux ondes, par exemple en étant parallèles entre eux et espacés d'une distance précise.

Le film 2 peut par exemple être réalisé en polycarbonate (ou PC), en polyamide (ou PA) ou encore en polytéréphtalate d'éthylène (ou PET). De préférence, le matériau choisi est chimiquement compatible avec la matière plastique formant le corps principal 6 de la pièce de carrosserie.

Alternativement, le dispositif électrique 4 peut ne pas être disposé sur un film 2. Dans ce cas, le ou les dispositifs électriques 4 sont positionnés directement dans un moule pour surmouler le corps principal 6 de la pièce de carrosserie sur ces derniers. On décrira par la suite un procédé de fabrication dans lequel un film 2 est utilisé, bien que les étapes décrites soient aussi réalisables avec un ou des dispositifs électriques 4 n'étant pas positionnés sur un film 2.

Le dispositif électrique 4 comprend un élément de contact électrique 8. On entend par élément de contact électrique 8 un élément conducteur d'électricité sur lequel un élément de connexion à une source d'énergie peut être relié et qui permettra le passage d'énergie depuis la source d'énergie (via l'élément de connexion) vers le dispositif électrique 4. Il permet donc une reprise de contact électrique. Il peut par exemple s'agir d'un plot en étain. Il pourrait néanmoins s'agir d'un autre type de contact électrique assurant la fonction décrite ci-dessus. Le matériau de ce dernier peut également varier, il peut par exemple est réalisé en argent.

Le nombre d'éléments de contact électrique 8 présents au niveau d'un dispositif électrique 4 peut varier. Par exemple, dans le cas d'un dispositif dégivrant formé par un réseau de fils de cuivre, il est possible d'avoir deux éléments de contact électrique 8 à chaque extrémité du réseau de fils de cuivre pour réduire la longueur de ce dernier et ainsi éviter les pertes d'énergie décrites plus haut.

La première étape du procédé de fabrication consiste à surmouler le corps principal 6 de la pièce de carrosserie sur le film 2 afin d'obtenir une première pièce intermédiaire 9 représentée sur la figure 2. Pour cela, il est possible de placer le film 2 dans un moule d'injection puis d'injecter la matière plastique formant le corps principal 6. Cette étape de surmoulage est connue de l'homme du métier, ainsi que les matériaux utilisés pour réaliser un corps principal en matière plastique. Il est par exemple possible d'utiliser un matériau transparent afin de voir le dispositif électrique, et plus particulièrement l'élément de contact électrique 8, et donc de faciliter l'étape de retrait de matière suite au surmoulage.

De préférence, le film 2 est surmoulé sur la face externe 10 de la pièce de carrosserie, c'est-à-dire la face visible depuis l'extérieur d'un véhicule lorsque la pièce de carrosserie est montée dessus. Cela permet d'obtenir un dégivrage plus efficace sans avoir à utiliser une quantité trop importante d'énergie.

L'épaisseur du corps principal 6 est constante car on évite des phénomènes comme les retassures décrites ci-dessus. Cela permet d'obtenir une pièce de carrosserie ayant un aspect satisfaisant après moulage.

Suite à l'étape de surmoulage, la première pièce intermédiaire 9 est reprise afin de retirer la partie du corps principal 6 recouvrant l'élément de contact électrique 8. Il est possible d'effectuer autant de retraits qu'il y a d'éléments de contact électrique 8. Un même retrait de matière plastique formant le corps principal 6 peut également mettre à nu plusieurs éléments de contact électrique 8.

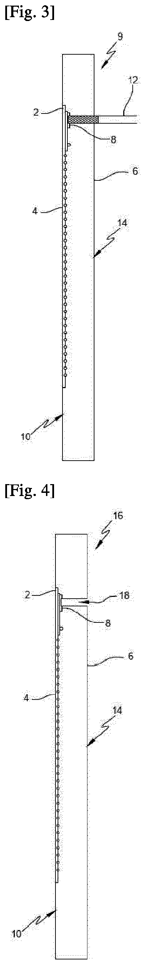

Cette étape de retrait peut être mise en œuvre par fraisage du corps principal 6 par une fraiseuse 12 dont seulement une partie est représentée sur la figure 3.

Alternativement, il est possible de prévoir dès l'étape de surmoulage une ou plusieurs zones de faiblesse ménagée au niveau du corps principal 6. Il s'agit de zones présentant une résistance mécanique inférieure au reste du corps principal 6 afin de pouvoir être facilement retirées par un opérateur.

Le retrait d'une ou plusieurs parties du corps principal 6 est de préférence réalisé sur la face interne 14 du corps principal, c'est-à-dire celle qui n'est pas visible depuis l'extérieur d'un véhicule lorsque la pièce de carrosserie est montée dessus et ce pour des raisons esthétiques.

Il est possible de prévoir que le ou les éléments de contact électrique aient une taille supérieure à celle de la ou des parties du corps principal retirées. En effet, et même si le positionnement du film 2 dans le moule est assez précis pour qu'un opérateur sache où il doit retirer de la matière plastique du corps principal 6 (ou pour s'assurer que la ou les zones de faiblesse sont au bon endroit), l'augmentation de la taille de l'élément de contact électrique 8 permet de s'assurer que le retrait de matière mette à nu ce dernier et ce même en cas de déplacement (dérive) du film 2 lors de l'étape de surmoulage.

Après l'étape de retrait d'une partie du corps principal 6, on obtient une seconde pièce intermédiaire 16 comprenant une ou plusieurs cavités 18 (une seule dans l'exemple illustré à la figure 4). L'élément de contact électrique 8 est visible au fond de cette cavité.

Enfin, l'élément de contact électrique 8 est connecté à un élément de connexion 20 du dispositif électrique 4 à une source d'énergie, par exemple la batterie du véhicule, afin d'obtenir la pièce de carrosserie 22. Cet élément de connexion 20 peut par exemple être un connecteur électrique relié à l'élément de contact électrique 8 par l'intermédiaire d'un fil conducteur. Dans ce cas, il est possible de souder le fil conducteur à l'élément de contact électrique 8, par exemple en mettant en fusion l'élément de contact électrique 8 si ce dernier est un plot en étain. Il est également possible de remplir au moins partiellement la cavité 18 avec un matériau conducteur après y avoir placé le fil conducteur pour assurer la continuité électrique entre l'élément de contact électrique 8 est l'élément de connexion 20.

Alternativement, l'élément de connexion 20 peut comprendre un contacteur à ressort, l'élément de contact 8 et l'élément de connexion 20 du dispositif électrique 4 à une source d'énergie étant connectés en montant le contacteur à ressort dans une cavité ménagée par le retrait de la partie du corps principal recouvrant l'élément de contact électrique 8. Le dimensionnement de la cavité 18 est donc déterminé par la forme du contacteur à ressort afin d'assurer le maintien de ce dernier en position dans la cavité 18.

La pièce de carrosserie 22 comprenant le dispositif électrique 4 peut dès lors être connectée à une source d'énergie lors de son montage sur un véhicule automobile.

L'invention n'est pas limitée aux modes de réalisation présentés et d'autres modes de réalisation apparaîtront clairement à l'homme du métier. Il est notamment possible de faire varier la nature de l'élément de contact électrique et de l'élément de connexion. Il est également possible d'envisager d'autres modes de connexion entre ces deux éléments.

### Liste de références numériques

2 : film
4 : dispositif électrique
6 : corps principal
8 : élément de contact électrique
9 : première pièce intermédiaire
10 : face externe de la pièce de carrosserie
12 : fraiseuse
14 : face interne de la pièce de carrosserie
16 : seconde pièce intermédiaire
18 : cavité
20 : élément de connexion
22 : pièce de carrosserie

## Revendications

1. Procédé de fabrication d'une pièce de carrosserie (22) de véhicule automobile comprenant au moins un dispositif électrique (4), le procédé comprenant les étapes suivantes :
- on surmoule un corps principal (6) de la pièce de carrosserie (22) sur le dispositif électrique (4), le procédé étant **caractérisé en ce que** :
- on retire au moins une partie du corps principal (6) recouvrant au moins un élément de contact électrique (8) du dispositif électrique (4) par cassure d'une zone de résistance mécanique inférieure au reste du corps principal (6) ménagée autour de la partie du corps principal (6) recouvrant l'élément de contact électrique (8), et
- on connecte l'élément de contact électrique (8) à un élément de connexion (20) du dispositif électrique (4) à une source d'énergie.

2. Procédé de fabrication selon la revendication 1, dans lequel le dispositif électrique (4) est un système de dégivrage d'une pièce de carrosserie.

3. Procédé de fabrication selon l'une quelconque des revendications précédentes, dans lequel l'élément de contact électrique (8) est un plot en étain.

4. Procédé de fabrication selon l'une quelconque des revendications précédentes, dans lequel le dispositif électrique (4) est surmoulé sur une face externe (10) du corps principal (6) visible depuis l'extérieur d'un véhicule automobile sur lequel la pièce de carrosserie (22) est montée.

5. Procédé selon l'une quelconque des revendications précédentes, dans lequel le dispositif électrique (8) est disposé sur un film (2), le corps principal (6) étant surmoulé sur le film (2).

6. Procédé selon l'une quelconque des revendications précédentes, dans lequel on retire la partie du corps principal (6) recouvrant l'élément de contact électrique (8) par fraisage.

7. Procédé de fabrication selon l'une quelconque des revendications précédentes, dans lequel la taille de l'élément de contact électrique (8) est supérieure à la taille de la partie du corps principal (6) le recouvrant étant retirée.

8. Procédé de fabrication selon l'une quelconque des revendications précédentes, dans lequel l'élément de connexion (20) du dispositif électrique (4) à une source d'énergie comprend un fil conducteur, connecté par soudage à l'élément de contact électrique (8).

9. Procédé de fabrication selon l'une quelconque des revendications précédentes, dans lequel l'élément de connexion (20) du dispositif électrique (4) à une source d'énergie comprend un contacteur à ressort, l'élément de contact électrique (8) et l'élément de connexion (20) du dispositif électrique (4) à une source d'énergie étant connectés en montant le contacteur à ressort dans une cavité ménagée par le retrait de la partie du corps principal (6) recouvrant l'élément de contact électrique (8).

10. Pièce de carrosserie (22) obtenue par le procédé selon l'une quelconque des revendications précédentes.

## Patentansprüche

1. Verfahren zur Herstellung eines Karosserieteils (22) eines Kraftfahrzeugs, das mindestens eine elektrische Vorrichtung (4) umfasst, aufweisend die Schritte:
- Umspritzen eines Hauptkörpers (6) des Karosserieteils (22) auf der elektrischen Vorrichtung (4), wobei das Verfahren **dadurch gekennzeichnet** ist:
- Entfernen mindestens eines Teils des Hauptkörpers (6), der mindestens ein elektrisches Kontaktelement (8) bedeckt, von der elektrischen Vorrichtung (4), indem eine Zone mit geringerer mechanischer Festigkeit als der Rest des Hauptkörpers (6), die um den Teil des Hauptkörpers (6), der das elektrische Kontaktelement (8) bedeckt, herum angeordnet ist, zerbrochen ist, und
- Verbinden des elektrischen Kontaktelementes (8) mit einem Verbindungselement (20) der elektrischen Vorrichtung (4) mit einer Energiequelle.

2. Verfahren nach Anspruch 1, wobei die elektrische Vorrichtung (4) ein System zur Enteisung eines Karosserieteils ist.

3. Verfahren nach einem der vorhergehenden Ansprüche, wobei das elektrische Kontaktelement (8) ein Zinnbolzen ist.

4. Verfahren nach einem der vorhergehenden Ansprüche, wobei die elektrische Vorrichtung (4) auf eine Außenseite (10) des Hauptkörpers (6) aufgespritzt wird, die von der Außenseite eines Kraftfahrzeugs, an dem das Karosserieteil (22) angebracht ist, sichtbar ist.

5. Verfahren nach einem der vorhergehenden Ansprüche, wobei die elektrische Vorrichtung (8) auf einer Folie (2) angeordnet ist, wobei der Hauptkörper (6) auf die Folie (2) aufgeformt wird.

6. Verfahren nach einem der vorhergehenden Ansprüche, wobei der Teil des Hauptkörpers (6), der das elektrische Kontaktelement (8) bedeckt, durch Fräsen entfernt wird.

7. Verfahren nach einem der vorhergehenden Ansprüche, wobei die Größe des elektrischen Kontaktelements (8) größer ist als die Größe des Teils des Hauptkörpers (6), der es abdeckt, der entfernt wird.

8. Verfahren nach einem der vorhergehenden Ansprüche, wobei das Verbindungselement (20) der elektrischen Vorrichtung (4) mit einer Energiequelle einen leitenden Draht umfasst, der durch Schweißen mit dem elektrischen Kontaktelement (8) verbunden ist.

9. Verfahren nach einem der vorhergehenden Ansprüche,
wobei das Verbindungselement (20) der elektrischen Vorrichtung (4) mit einer Energiequelle einen Federkontakt umfasst,
wobei das elektrische Kontaktelement (8) und das Verbindungselement (20) der elektrischen Vorrichtung (4) mit einer Energiequelle durch Anbringen des Federkontakts in einem Hohlraum verbunden werden, der durch Entfernen des Teils des Hauptkörpers (6), der das elektrische Kontaktelement (8) bedeckt, geschaffen wird.

10. Karosserieteil (22), das durch das Verfahren nach einem der vorhergehenden Ansprüche hergestellt wurde.

## Claims

1. Manufacturing method of a motor vehicle bodywork part (22) comprising at least one electrical device (4), the method comprising the following steps:
- a main body (6) of the bodywork part (22) is overmolded on the electrical device (4), the method being **characterized in that**:
- at least one part of the main body (6) covering at least one electrical contact element (8) of the electrical device (4) is removed by breaking an area of mechanical strength lower than the rest of the main body (6) around the part of the main body (6) covering the electrical contact element (8), and
- the electrical contact element (8) is connected to a connection element (20) of the electrical device (4) to an energy source.

2. Manufacturing method according to claim 1, wherein the electrical device (4) is a bodywork part defrosting system.

3. Manufacturing method according to any one of the preceding claims, wherein the electrical contact device (8) is a tin stud.

4. Manufacturing method according to any one of the preceding claims, wherein the electrical device (4) is overmolded on an external face (10) of the main body (6) visible from the outside of a motor vehicle on which the body part (22) is mounted.

5. Manufacturing method according to any one of the preceding claims, wherein the electrical contact element (8) is arranged on a film (2), the main body (6) being overmolded on the film (2).

6. Manufacturing method according to any one of the preceding claims, wherein the part of the main body (6) covering the electrical contact element (8) is removed by milling.

7. Manufacturing method according to any one of the preceding claims, wherein the size of the electrical contact element (8) is greater than the size of the part of the main body (6) covering it and being removed.

8. Manufacturing method according to any one of the preceding claims, wherein the connecting element (20) of the electrical device (4) to an energy source comprises a conductive wire, connected by welding to the electrical contact element (8).

9. Manufacturing method according to any one of the preceding claims, wherein the connecting element (20) of the electrical contact device (4) to an energy source comprises a spring contactor, the electrical contact element (8) and the connection element (20) of the electrical contact device (4) to an energy source being connected by mounting the spring contactor in a cavity provided by the removal of the part of the main body (6) covering the electrical contact element (8).

10. Bodywork part (22) obtained by the method according to any one of the preceding claims.
